# EUROPÄISCHE PATENTANMELDUNG

(11) **EP 3 986 095 A1**
(43) Veröffentlichungstag der Anmeldung: **20.04.2022**
(21) Anmeldenummer: 21201679.4
(22) Anmeldetag: 08.10.2021
(51) Int. Cl.: H05K 1/18, H05K 7/02

(54) **RELAISANORDNUNG**

(30) Priorität: 19.10.2020 DE 202020105965 U
(71) Anmelder: Weidmüller Interface GmbH & Co. KG, 32758 Detmold (DE)
(72) Erfinder: GERKENS, Michael, 33617 Bielefeld (DE); JANIK, Joachim, 32429 Minden (DE)
(74) Vertreter: Kleine, Hubertus

(57) **Zusammenfassung**

Anordnung (10) eines Relais (11) zum Schalten eines Leistungspfads und mindestens einer mit dem Leistungspfad gekoppelten Baugruppe (12a, 12b), wobei die mindestens eine Baugruppe (12a, 12b) und das Relais (11) übereinandergestapelt angeordnet sind, wobei an einer dem Relais (11) gegenüberliegenden Seite der mindestens einen Baugruppe (12a, 12b) Anschlusselemente (13) zum Verbinden mit einer Leiterkarte (1) vorhanden sind, und wobei Anschlüsse des Relais (11) durch die mindestens eine Baugruppe (12a, 12b) zu den Anschlusselementen (13) geführt sind.

## Beschreibung

Die Erfindung betrifft eine Anordnung eines Relais zum Schalten eines Leistungspfads und mindestens einer mit dem Leistungspfad gekoppelten Baugruppe.

Steuereinrichtungen verwenden häufig Relais, um große Leistungen zu schalten. Ein Beispiel sind Anschlussvorrichtungen (z.B. Ladesäulen oder sog. Wall-Boxen) zum Aufladen von Elektrofahrzeugen. Diese Anschlussvorrichtungen sind üblicherweise über ein mehrphasiges, typischerweise dreiphasiges Anschlusskabel mit einem Stromversorgungsnetz verbunden. Die Anschlussvorrichtungen bieten die Möglichkeit, ein speziell für diesen Zweck geeignetes Verbindungskabel (Ladekabel) einzustecken, das mit seinem freien Ende mit dem Fahrzeug verbunden wird. Alternativ kann das Ladekabel fest an die Anschlussvorrichtung angeschlossen sein. Im Ladekabel sind neben Stromversorgungsleitungen, über die Strom zum Laden der Batterie des Fahrzeugs übertragen wird, auch Signal- bzw. Datenleitungen angeordnet, um Parameter des Ladevorgangs zwischen der Anschlussvorrichtung und dem Fahrzeug auszutauschen. Über diese zusätzlichen Signal- bzw. Datenleitungen erfolgt auch eine Freigabe der Lieferung des Ladestroms durch eine Steuereinrichtung der Anschlussvorrichtung, falls geeignete Parameter vorliegen oder seitens des Fahrzeugs oder der Anschlussvorrichtung eingestellt wurden. Nach Freigabe wird ein in der Steuereinrichtung vorhandenes Relais eingeschaltet, um Ladestrom über das Ladekabel zu liefern.

Neben dem eigentlichen Schaltvorgang, der von dem Relais vorgenommen wird, übernimmt die Steuereinrichtung in der Regel weitere Aufgaben, die im Zusammenhang mit der von dem Relais geschalteten Leistung stehen. Beispielsweise wird die vom Relais geschaltete Leistung gemessen und/oder Fehlerströme des geschalteten Stroms werden ermittelt, um Sicherheitsanforderungen zu erfüllen. Zu diesem Zweck sind in den Steuereinrichtungen eine oder mehrere weitere Baugruppen enthalten, die die genannten Aufgaben an dem vom Relais geschalteten Leistungspfad vornehmen.

Eine bekannte Ausgestaltung sieht vor, das Relais ebenso wie die genannte mindestens eine Braugruppe auf einer Leiterkarte der Steuereinrichtung anzuordnen. Der von dem Relais geschaltete Leistungspfad verläuft dann in Form von Leiterbahnen über die Leiterkarte und ist auf diesem Weg auch durch Abschnitte der Leiterkarte geführt, in denen diese Baugruppe(n) angeordnet ist bzw. sind, um die entsprechenden Messungen oder Überwachungen am Leistungspfad vornehmen zu können. Diese Art der Anordnung von Relais und Baugruppe(n) führt zu einem über relativ weite Strecken auf der Leiterkarte in Form von Leiterbahnen geführten Leistungspfad. Dieses ist aufwendig, weil bei höherer geschalteter Leistung Leiterkarten mit besonders dicken Leiterbahnen eingesetzt werden müssen und/oder für die stromtragenden Leiterbahnen eine große Fläche auf der Leiterkarte vorgesehen werden muss.

Es ist daher eine Aufgabe der vorliegenden Erfindung, eine Anordnung der eingangs genannten Art in einer möglichst kompakten Bauform bereitzustellen, um eine Länge eines auf einer Leiterkarte ausgebildeten Leistungspfads möglichst kurz halten zu können.

Diese Aufgabe wird durch eine Anordnung eines Relais zum Schalten eines Leistungspfads und mindestens einer mit dem Leistungspfad gekoppelten Baugruppe mit den Merkmalen des unabhängigen Anspruchs gelöst. Vorteilhafte Ausgestaltungen und Weiterbildungen sind Gegenstand der abhängigen Ansprüche.

Eine erfindungsgemäße Anordnung zeichnet sich dadurch aus, dass die mindestens eine Baugruppe und das Relais übereinandergestapelt angeordnet sind, wobei an einer dem Relais gegenüberliegenden Seite der mindestens einen Baugruppe Anschlusselemente zum Verbinden mit einer Leiterkarte vorhanden sind und wobei Anschlüsse des Relais durch die mindestens eine weitere Baugruppe zu den Anschlusselementen geführt sind.

Anders als aus dem Stand der Technik bekannt, werden die mindestens eine Baugruppe und das Relais übereinander in Form eines Stapels (Stacks) ausgebildet und können somit als Einheit auf der Leiterkarte angeordnet und verbunden werden. Der von dem Relais geschaltete Leistungspfad verläuft von den Anschlusselementen, mit denen diese Einheit die Leiterkarte kontaktiert, dann in einer Richtung senkrecht zur Ebene der Leiterkarte durch die mindestens eine Baugruppe in das Relais. Der in Form von Leiterbahnen auf der Leiterkarte geführte Teil des Leistungspfads kann so in seiner Länge minimiert werden. Zusätzlich wird die Leiterkartenfläche dadurch reduziert, dass die Baugruppe und das Relais übereinander angeordnet sind und somit letztlich nur die Fläche der größeren der beiden Komponenten, in der Regel des Relais, benötigt wird.

Die Anschlusslemente zu einem direkten Verbinden mit der Leiterkarte beispielsweise als Lötpins zum Einstecken in Bohrungen der Leiterkarte und Einlöten ausgebildet sein. Alternativ können sie auch als Lötpads zum Auflöten auf die Leiterkarte oder als Durchsteckkontakte ausgebildet sein. In einer weitere Alternative können die Anschlusselemente Steckkontakte zum Einstecken in einen Stecksockel sein, der dann auf die Leiterkarte gelötet ist. In dem Fall erfolgt die Kontaktierung der Leiterkarte durch die Anschlusselemente indirekt über den Stecksockel.

Das Stapelkonzept kann dabei auf mehrere Baugruppen übertragen werden, die in Form von parallel zur Leiterkarte ausgerichteten Scheiben übereinander angeordnet sind, wobei auf der oberen der Scheiben das Relais positioniert ist.

Die mindestens eine Baugruppe und das Relais können dabei mechanisch und elektrisch fest miteinander verbunden sein. Alternativ ist es möglich, ein Stecksystem zwischen den Baugruppen untereinander und/oder der oberen Baugruppe und dem Relais über ein Stecksystem zu realisieren. Dieses hat den Vorteil, dass Baugruppen ausgetauscht oder erweitert werden können. Bei Verwendung eines Stecksystems kann die untere Baugruppe unmittelbar die Leiterkarte kontaktieren oder ihrerseits in einen Sockel eingesteckt sein, der dann mit der Leiterkarte verbunden ist.

Die mindestens eine Baugruppe kann z. B. eine Leistungs- oder Energiemesseinheit sein, durch die eine durch den Leistungspfad fließende Leistung bzw. Energie ermittelt wird. Ein anderes Beispiel der mindestens einen Baugruppe ist eine Fehlerstrommesseinheit, die einen Wechselstrom (AC)-Fehlerstrom und/oder einen Gleichstrom (DC)-Fehlerstrom ermittelt. Die weitere Baugruppe kann auch als (ggf. bidirektional wirkender) Überspannungsschutz ausgebildet sein.

Die Erfindung wird nachfolgend anhand eines Ausführungsbeispiels mithilfe einer Figur näher erläutert. Die einzige Figur zeigt:

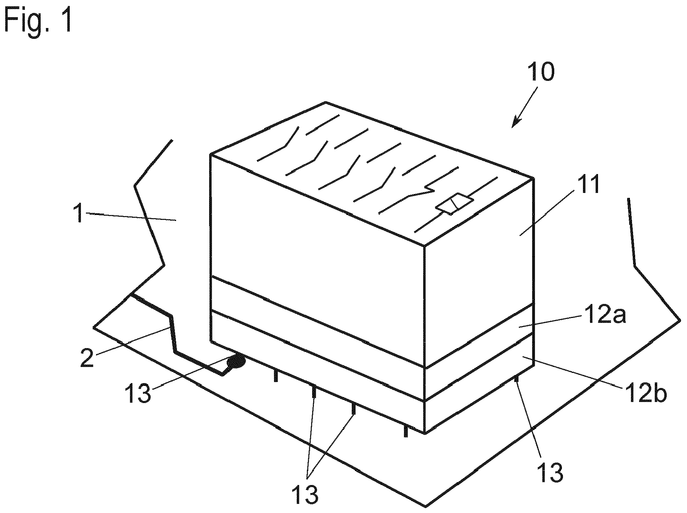

- Fig. 1: eine schematische isometrische Darstellung einer Anordnung aus einem Relais und zwei Baugruppen.

In Figur 1 ist ein Ausschnitt einer Leiterkarte 1 dargestellt, beispielsweise der Leiterkarte einer Steuereinrichtung einer Ladesäule oder Wallbox zum Laden eines Elektrofahrzeugs. Auf der Leiterkarte ist eine anmeldungsgemäße Anordnung 10 aus einem Relais 11 und vorliegend zwei Baugruppen 12a, b angeordnet. Die Anordnung 10 wird nachfolgend auch als Kombimodul 10 bezeichnet.

Das Relais 11 ist, wie das Piktogramm auf seiner Oberseite andeutet, ein Leistungsrelais mit vier Schaltkontakten, einem Überwachungskontakt sowie einer Spule, die die genannten Kontakte betätigt. Die Leistungskontakte können beispielsweise ein dreiphasiges Wechselstromnetz sowie einen zugeordneten Nullleiter schalten. Die Anzahl der Schaltkontakte ist dabei rein beispielhaft, ein anmeldungsgemäßes Kombimodul 10 kann auch mit einem Relais 11 mit einer abweichenden Anzahl von Schalt- und/oder Überwachungskontakten ausgebildet sein. Das Relais 11 weist eine für derartige Relais typische kubische Bauform auf.

Zwischen der Leiterkarte 1 und dem Relais 11 sind vorliegend zwei Baugruppen 12a, b angeordnet, die ebenfalls eine kubische Bauform mit gleichem Aufmaß wie das Relais 11 aufweisen. Die Baugruppen 12a, b können beispielsweise eine Einheit zur Energiemessung und ein DC und/oder AC-Fehlerstrommesseinheit sein. Die Anzahl der hier zwei Baugruppen 12a, b ist beispielhaft. Es kann auch nur eine Baugruppe oder es können mehr als zwei Baugruppen vorgesehen sein.

An der unteren der beiden Baugruppen 12b sind Anschlusselemente 13 angeordnet, hier in der Form von Lötpins. Die Lötpins ragen in entsprechende Bohrungen der Leiterkarte 1 und sind mit Leiterbahnen 2 verlötet. Von den Leiterbahnen 2 ist in der Figur 1 lediglich eine schematisch und beispielhaft angedeutet.

Mit zumindest einem Teil der Anschlusselemente 13 sind Leiter verbunden, die im Inneren des Kombimoduls 10 durch die Baugruppen 12a, b bis zu dem Relais 11 führen. Die Anschlüsse des Relais 11, darunter auch die Anschlüsse der Schaltkontakte und damit die Leistungspfade der Anordnung, sind so auch in den Baugruppen 12a, b verfügbar, beispielsweise zu Messzwecken. Auch Steuerpfade des Relais 11, z. B. die Anschlüsse seiner Spule sind in den Baugruppen 12a, b verfügbar. Somit kann beispielsweise vorgesehen sein, dass diejenige der Baugruppen 12a, b, die eine Fehlerstrommessung vorsieht, bei Detektion eines oberhalb eines Grenzwertes liegenden Fehlerstroms den Strom zur Spule des Relais 11 auch unterbricht. Somit können die Baugruppen 12a, b nicht nur messende Funktion am Leistungspfad innehaben, sondern auch Schaltfunktionen für das Relais 11. Damit lässt sich als Baugruppe 12a, b beispielsweise auch eine Einschaltfunktion für das Relais 11 nur bei unbelasteten Leistungspfaden realisieren.

Neben denjenigen der Anschlusselemente 13, die bis in das Relais 11 durchgeführt sind, können auch Anschlusselemente 13 vorhanden sein, die nur von einer oder mehreren der Baugruppen 12a, b bis in die Leiterkarte 1 führen, beispielsweise um Ergebnisse von Messungen oder sonstige Signale zwischen den Baugruppen 12a, b und der Leiterkarte 1 austauschen zu können.

Die mechanische und auch elektrische Verbindung der Baugruppen 12a, b untereinander sowie mit dem Relais 11 kann bei Herstellung des Kombimoduls 10 fixiert werden. In dem Fall ist das Kombimodul 10 eine in sich abgeschlossene Einheit, die als ein Block die Leiterkarte 1 direkt kontaktiert, oder die in einen Stecksockel, der sich zwischen der Leiterkarte 1 und dem Kombimodul 10 befindet, eingesteckt wird. In alternativen Ausgestaltungen können zwischen den Baugruppen 12a, b untereinander und/oder dem Relais 11 Steckverbindungen vorgesehen sein, sodass sich das Kombimodul 10 durch aufeinanderfügen der Baugruppen 12a, b und dem Relais 11 flexibel zusammenstellen lässt. In dem Fall können defekte Baugruppen oder ein verschlissenes Relais 11 problemlos ausgetauscht werden. Auch hier kann die untere der Baugruppen 12a, b fest in die Leiterkarte 1 eingelötet sein oder in einen Stecksockel eingesteckt sein. Dabei können bekannte Steckverbindungen z.B. mithilfe von Tulpenkontakten oder Messer- bzw. Gabelkontakten eingesetzt werden.

Dabei kann eine mechanische Kodierung der verschiedenen Baugruppen 12a, b vorgesehen sein, z.B. durch verschieden geformte und/oder positionierte Stifte bzw. Vertiefungen an den zueinander zugewandten Flächen der Baugruppen 12a, 12b und ggf. des Relais 11. Die Kodierung verhindert ungeeignete Kombinationen von nicht miteinander harmonisierenden Baugruppen 12a, b bzw. des Relais 11 und/oder ungeeignete Stapel-Reihenfolgen der Baugruppen 12a, b.

Durch das anmeldungsgemäße Kombimodul 10 wird Leiterkartenplatz eingespart, da die Baugruppen 12a, b und das Relais 11 auf der Leiterkarte lediglich den Leiterkartenplatz beanspruchen, den das Relais 11 auch alleine belegen würde. Zudem verringern die senkrecht zur Leiterkarte 1 durch die Baugruppen 12a, b geführten Leistungspfade die Länge der in Form von Leiterbahnen 2 auf der Leiterkarte 1 geführten Leistungspfade.

### Bezugszeichenliste

- 1: Leiterkarte
- 2: Leiterbahn

- 10: Anordnung (Kombimodul)
- 11: Relais
- 12a, b: Baugruppe
- 13: Anschlusselement

## Patentansprüche

1. Anordnung (10) eines Relais (11) zum Schalten eines Leistungspfads und mindestens einer mit dem Leistungspfad gekoppelten Baugruppe (12a, 12b), **dadurch gekennzeichnet, dass**
die mindestens eine Baugruppe (12a, 12b) und das Relais (11) übereinandergestapelt angeordnet sind, wobei an einer dem Relais (11) gegenüberliegenden Seite der mindestens einen Baugruppe (12a, 12b) Anschlusselemente (13) zum Verbinden mit einer Leiterkarte (1) vorhanden sind, und wobei Anschlüsse des Relais (11) durch die mindestens eine Baugruppe (12a, 12b) zu den Anschlusselementen (13) geführt sind.

2. Anordnung (10) nach Anspruch 1, bei der mindestens zwei Baugruppen (12a, 12b), durch die die Anschlüsse des Relais (11) geführt sind, vorhanden sind.

3. Anordnung (10) nach Anspruch 2, bei der die mindestens zwei Baugruppen (12a, 12b) ihrerseits aufeinander angeordnet sind.

4. Anordnung (10) nach einem der Ansprüche 1 bis 3, bei der die mindestens eine Baugruppe (12a, 12b) und/oder das Relais (11) mechanisch und elektrisch fest miteinander verbunden sind.

5. Anordnung (10) nach einem der Ansprüche 1 bis 4, bei der die mindestens eine Baugruppe (12a, 12b) und/oder das Relais (11) mechanisch und elektrisch über ein Stecksystem verbunden sind.

6. Anordnung (10) nach einem der Ansprüche 1 bis 5, bei der die Anschlusselemente (13) für eine direkte Verbindung mit der Leiterkarte (1) ausgebildet sind.

7. Anordnung (10) nach Anspruch 6, bei der die Anschlusselemente (13) Lötpins, Lötpads und/oder Durchsteckkontakte sind.

8. Anordnung (10) nach einem der Ansprüche 1 bis 5, bei der die Anschlusselemente (13) als Steckkontakte für eine indirekte Verbindung über einen Stecksockel mit der Leiterkarte (1) ausgebildet sind.

9. Anordnung (10) nach einem der Ansprüche 1 bis 8, bei der die mindestens eine Baugruppe (12a, 12b) eine Leistungs- oder Energiemesseinheit ist.

10. Anordnung (10) nach einem der Ansprüche 1 bis 9, bei der die mindestens eine Baugruppe (12a, 12b) eine Überspannungsschutzeinheit ist.

11. Anordnung (10) nach einem der Ansprüche 1 bis 10, bei der die mindestens eine Baugruppe (12a, 12b) eine Fehlerstrommesseinheit ist.

12. Anordnung (10) nach Anspruch 11, bei der die Fehlerstrommesseinheit zur Messung eines Wechselstrom-Fehlerstroms und/oder eines Gleichstrom-Fehlerstroms ausgebildet ist.

13. Anordnung (10) nach Anspruch 11 oder 12, ausgebildet als Fehlerstromschutzeinheit, wobei die Fehlerstrommesseinheit auf Anschlüsse einer Spule des Relais (11) wirkt.
